# EUROPEAN PATENT APPLICATION

(11) **EP 0 660 250 A1**
(43) Date of publication of application: **28.06.1995**
(21) Application number: 94105869.5
(22) Date of filing: 15.04.1994
(51) Int. Cl.: G06F 17/50

(54) **Method and system for evaluating simulation signals**

(30) Priority: 20.12.1993 US 170392
(71) Applicant: CADENCE DESIGN SYSTEMS, San Jose, California 95134 (US)
(72) Inventor: Hubbard,Paul E., Euclid,Ohio 44119 (US); Ordy,Greg M., Chesterland,Ohio 44026 (US)
(74) Representative: Liesegang, Roland, Dr.-Ing.

(57) **Abstract**

A process and system are provided for optimizing the evaluation of signals in a simulation model. Optimization is achieved by generating for each signal in the simulation a customized method chain for computing only those attributes which are used by the signal. A method chain is generated for a particular signal by first determining which attributes are used by the signal. This determination is performed by traversing the design hierarchy of the simulation model. A list of used attributes is thus derived. Thereafter, the method chain is generated by first providing a plurality of method implementation code fragments, each code fragment being a set of computer code designed to perform a selected function. Once the code fragments are provided, the next step is to determine which functions, and hence, which code fragments, are needed to compute the used attributes. A list of needed code fragments is derived by traversing the list of used attributes and determining which functions need to be performed for each attribute. Once it is known which code fragments are needed, a method data structures is generated to call each of the needed fragments. These data structures are linked together to form the method chain for the signal. A method chain formed using this process will compute only those attributes which are actually used by the signal in the simulation. Since no extraneous attributes are computed, signal evaluation is optimized.

## Description

### Field of the Invention

This invention relates to software logic simulators and more particularly to a method and system for optimizing the evaluation of simulation signals generated by a software logic simulator to improve the speed performance of the simulator.

### Description of the Prior Art

The present state of the electronics art allows electronics manufacturers to produce progressively complex logic circuits, systems, and devices. As the circuits become more complex, the ability to effectively and efficiently simulate the circuits becomes more important. Simulation allows a circuit to be tested to determine whether it functions properly before the circuit is actually produced. If, through simulation, the design of the circuit is found to be defective, the design flaw can be corrected before substantial amount of resources are invested into producing the circuit. Thus, logic simulation prevents the waste of valuable resources.

Complex circuits and devices are typically simulated by means of a software simulator. In a software simulator, circuit components are modeled through the use of computer code to exhibit certain characteristics and behaviors. The interconnections among the various components are also software modeled. Once the modeling of the circuit is complete, the computer code used to model the circuit is executed to simulate the operation of the circuit. By feeding various inputs to the components, and by monitoring the outputs from the components, the workings of the cirucit can be tested and verified. The design of the circuit may thus be checked for flaws before construction of the circuit is commenced.

A common computer language used for modeling the components and interconnections of a logic circuit is the VHSIC hardware description language (VHDL). The standards for the VHDL language are set forth in the "IEEE Standard VHDL Language Reference Manual" (LRM) published by the Institute of Electrical and Electronics Engineers, Inc. In VHDL, each of the individual components of a logic circuit is modeled as a "process", where each process is a set of computer code designed to exhibit the characteristics and behaviors of the actual component. The interconnections among the various components are modeled as "signals". Each of these "signals" is a set of computer code designed to calculate the values of the actual signals passing between the actual components to provide an accurate model of the communication pathways between the components. In most actual circuits, each component of the circuit communicates with at least one and, most likely, more than one other component of the circuit. Hence, the number of signals is usually significantly greater than the number of processes. Once the actual circuit is properly modeled by processes and signals using VHDL code, the operation of the circuit is simulated by executing the processes and evaluating the signals in accordance with a predetermined schedule. Because the number of signals is significantly greater than the number of processes, evaluation of the signals consumes a majority of the simulation time. Consequently, the speed of signal evaluation determines in large part the speed of simulation.

The LRM describes the requirements for evaluating signals using the VHDL language; however, no specific process of method for implementing signal evaluation is set forth. Currently, signal evaluation is performed by way of a single generic program code fragment which evaluates all of the signals in the circuit model. While this evaluation method works properly, it is highly inefficient. In VHDL, each signal is characterized by nine attributes, but not all nine attributes need to be computed for every signal. In fact, most signals require that only a subset of the attributes be computed. The generic program, however, cannot take the specific needs of individual signals into account. It is a general program and, as such, it must accommodate all of the signals in the modeled system. Since some of the signals in the simulation model may use all nine attributes, the program must compute all nine attributes for each and every signal, regardless of whether that particular signal requires all nine. Needless to say, computing unnecessary attributes is a waste of valuable computation time. Because a majority of simulation time is attributed to signal evaluation, inefficient signal evaluation has a significant negative impact on the overall speed of the logic simulator. Hence, the prior art method for evaluating signals fails to provide satisfactory results. Consequently, there is a need for an improved signal evaluation method which optimizes the evaluation of the signals in a logic simulation system to improve the overall speed performance of the system.

### Summary of the Invention

The present invention is partially based on the observation that signal evaluation may be optimized by computing, for each individual signal, only those attributes which are used in the simulation. In accordance with this observation, the present invention provides a process whereby a customized method chain is generated for each signal in the simulation to compute the attributes used by that signal. Each method chain preferably comprises a plurality of methods, each method performing a selected function. Together, the methods of the method chain perform all of the functions necessary for computing the used attributes.

To generate a method chain for a particular signal, it is first determined which attributes are actually used by that signal in the simulation. This is preferably accomplished by pre-analyzing the design hierarchy of the circuit model of which the signal is a part. This pre-analysis is analogous to a preliminary simulation of the circuit model which allows the needs of the signal to be predetermined. Once the attributes used by the signal are known, the method chain is generated by first providing a plurality of method implementation code fragments. Each of these code fragments is a set of computer code which is designed to perform a selected function; and each is preferably an independent module which may be independently accessed. Based on the attributes used by the signal, it is determined which functions need to be performed, and hence, which of these code fragments need to be called by the method chain. Based on this information, a plurality of method data structures are generated, each data structure calling one of the code fragments to perform one of the functions necessary to compute the used attributes. Once generated, the method data structures are preferably linked to one another to form the method chain for the signal. Note that the method chain formed using the process of the present invention computes only those attributes which are used by the signal. No unnecessary attributes are computed. After the method chain is generated, the simulation signal is evaluated by executing the methods on the method chain. Because no unnecessary functions are performed by the method chain, the evaluation of the signal will be optimized.

### Brief Description of the Drawings

Fig. 1 is a flow diagram of the overall simulation methodology of the present invention.

Fig. 2 is a circuit diagram of a simple test circuit.

Fig. 3 shows a software model of the test circuit shown in Fig. 2 using VHDL processes and signals.

Fig. 4 is a flow diagram illustrating the elaboration process of the present invention.

Fig. 5 is a table of the nine attributes which are used to characterize a signal in VHDL.

Fig. 6 is a flow diagram illustrating the process of generating a method chain in accordance with the present invention.

Fig. 7 is a graphical representation of a method data structure of the present invention.

Fig. 8 shows a method chain of the present invention to illustrate the links between the various data structures within the method chain.

Fig. 9 is a graphical representation of the various elements in the simulation system of the present invention to show the sharing of the method implementation codes amount a plurality of data structures.

Fig. 10 is a flow diagram of the process of dynamically inserting a method into an existing method in accordance with the present invention.

Fig. 11 shows a method chain of the present invention to illustrate the insertion of a method into an existing method chain.

Fig. 12 is a block diagram of a computer system which implements the process of the present invention.

### Detailed Description of the Preferred Embodiment

The present invention provides a method and system for optimizing the evaluation of signals in a logic simulation model. Before the invention is described in detail, however, a brief discussion of the overall simulation methodology will be provided to facilitate a thorough understanding of the invention.

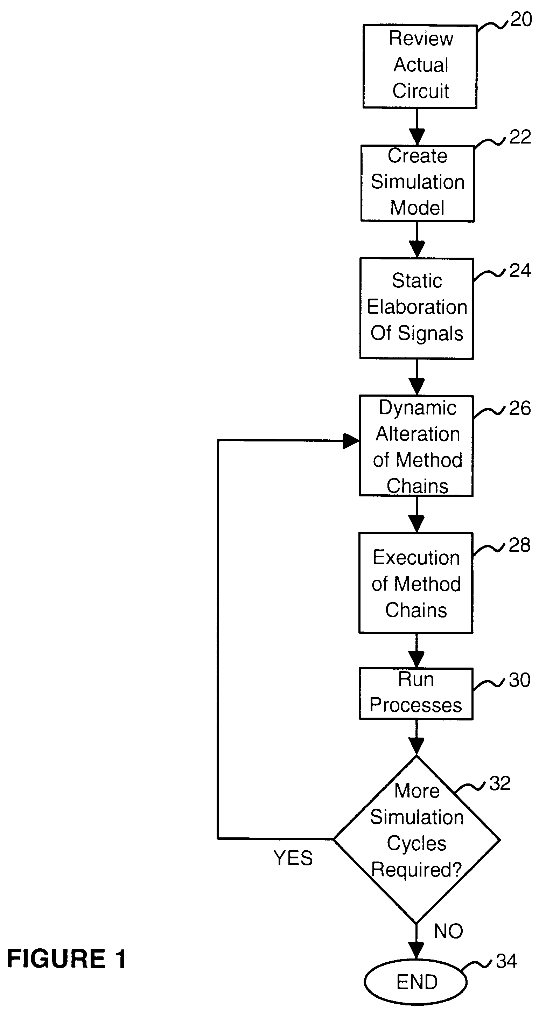

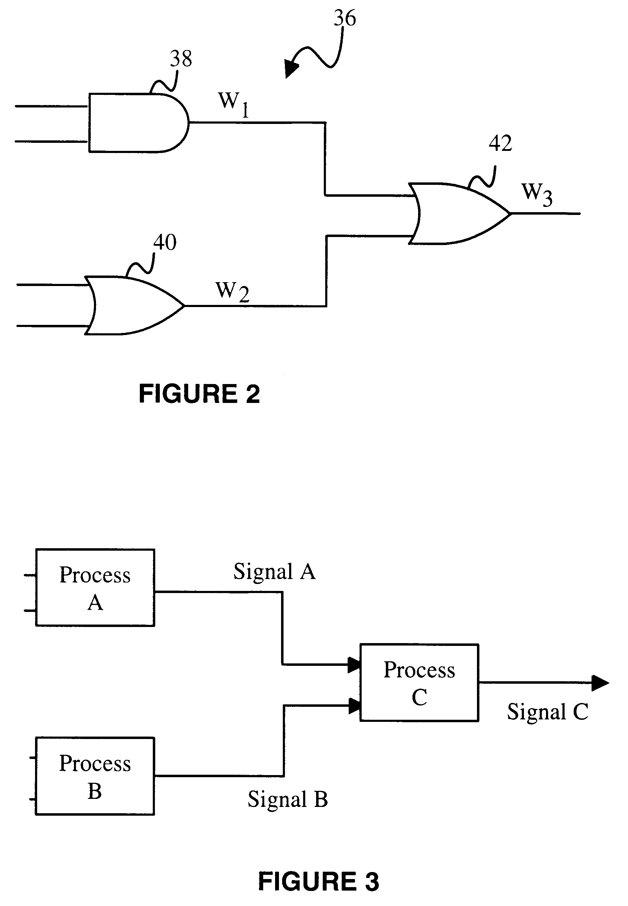

With reference to Fig. 1, there is shown a flow diagram of the simulation methodology of the present invention. The simulation provess begins with a review 20 of the circuit, device, or system to be simulated to determine the scope and nature of the simulation. The circuit to be simulated may be a simple three gate circuit 36 such as that shown in Fig. 2, or it may be a complex microprocessing device. A thorough review 20 of the circuit 36 allows the simulation programmer to identity the components 38, 40, 42 of the circuit 36 and a communication pathways W₁, W₂, W₃ which connect the components.

After reviewing the test circuit 36, the programmer creates a simulation model of the actual circuit, preferably using a hardware description language (HDL). For the sake of illustration and simplicity, it is assumed for the purpose of this disclosure that the HDL used to model the actual circuit 36 is the VHSIC hardware description language (VHDL), but it should be noted that other languages may be used. In VHDL, the components 38, 40, 42 of an actual circuit 36 are modeled as "processes", where a "process" is a set of computer code which is designed to exhibit the characteristics and behaviors of a certain component. Each process is characterized by an entity declaration, which provides an "external" description of the modeled component, and an architectural body, which describes the "internal" behavior or structure of the modeled component. To complete the model of the circuit 36, the communications pathways W₁, W₂, W₃ of the circuit are also modeled, and these pathways are modeled as "signals". A "signal" in VHDL is an object which is programmed to exhibit the attributes and values of the actual connections W₁, W₂, W₃ between the components 38, 40, 42. Using processes and signals, the simple circuit of Fig. 2 may be modeled as shown in Fig. 3, wherein the three gates 38, 40, 42 modeled as processes A, B, and C, respectively, and the wires W₁, W₂, W₃ are modeled as signals A, B, and C, respectively. In the model of Fig. 3, process A "drives" signal A with a driving value, and process C "reads" the effective value of signal A. In a simulation model in which each signal is driven by only one process driver, the driving value and the effective value of a signal are equivalent.

For simple circuit models such as that shown in Fig. 3, the concept of a design hierarchy is probably not important, but for very complex circuits, it is important to model the components and connections hierarchically so that related components are grouped together and considered as a single unit in the next higher level of the hierarchy. Such a design hierarchy simplifies the model and makes it much more manageable. The design hierarchy of a circuit model is specified by the person crating the model. The first two steps 20, 22 in the simulation methodology thus far described are generally known in the art and will not be elaborated upon further herein.

After a simulation model is produced and its design hierarchy specified, the process of static elaboration 24 is entered. It is during this step 24 that a customized data chain is generated for each signal to compute the attributes used by the signal in the simulation. Each method chain preferably comprises a plurality of methods, each method performing a selected function and each linked to at least one other method to form the method chain. Preferably, each method chain includes only those methods which are necessary for computing the used attributes and for supporting the simulation. The elaboration step 24 will be described in greater detail in a subsequent section.

After elaboration, all of the elements needed for simulation have been generated; hence, the simulation process may be commenced. In the first step 26 of the process, any of the method chains generated during elaboration may be altered 26 by dynamically adding or removing a method from the method chain during simulation. This step 26 allows the person running the simulation to further customize each of the method chains to fit his needs. If, for example, the user wishes to monitor a particular signal during simulation, he can simply insert a monitor method into the method chain of that particular signal to cause a monitoring function to be performed. Conversely, if the user no longer wishes to monitor the signal, the monitor method may be removed from the method chain. Thus, each method chain may be further customized during simulation to add functionality to the chain or to reduce the number of functions performed by the chain to ensure that no unnecessary functions are performed. This step 26 will be described in greater detail in a later section.

When all of the method chains are in a form satisfactory to the user, the method chains are executed 28 to "evaluate" each of the signals in the simulation. In this step 28, the methods within each of the method chains are executed to compute the attributes used by each of the signals and to perform all other functions necessary to support the simulation process. Once the signals are evaluated, the processes in the circuit model are run 30 using the newly evaluated signal values. Since it is the processes which drive the signals, the running of the processes will probably cause at least some of the signals to be driven with new values. These new values will appear in the next simulation cycle, if there is one. If another simulation cycle is required 32, then steps 26-32 are repeated; otherwise, the simulation is complete and the simulation program stops running 34. Whether another simulation cycle is required is determined by a separate computer program known as a scheduler. A scheduler, which is generally known in the art, is not a subject of the present invention and, thus, will not be described in detail herein. For the purposes of the present invention, it is sufficient to just note that the sequence of simulation events is controlled by a scheduler program.

Given this overall simulation context, the signal evaluation process and system of the present invention will now be described in detail. For the sake of illustration and clarity, the invention will be described in terms of the VHDL language, but it should be noted that the invention may be implemented using other hardware description languages so long as those languages use the concept of a "signal" to model a connection between circuit components. Typically, a signal is said to be evaluated when its attributes and other values are computed. For the signals in the present invention, however, evaluation cannot occur until the method chains have been elaborated. Since the celebration step is so closely connected with the evaluation step in the present invention, the elaboration of a signal will herein be considered a part of the evaluation process.

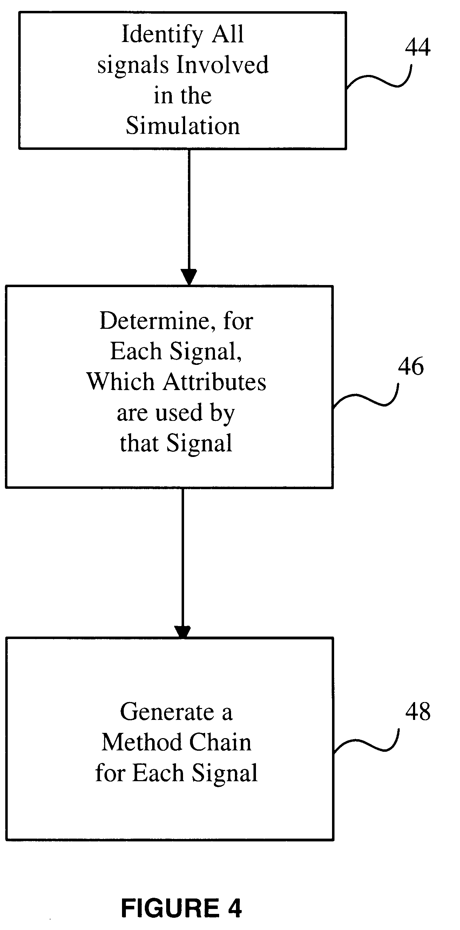

Referring to Fig. 4, there is shown a block diagram of the elaboration process of the present invention. The purpose of this process is to generate a customized method chain for each signal in the simulation model to compute the attributes used by the signal, and to perform any functions necessary for supporting the simulation. The logical first step then is to identify 44 the signals in the simulation model. In VHDL, each signal is declared as a signal, so that identifying the signals in the simulation model merely requires that the signal declarations be found.

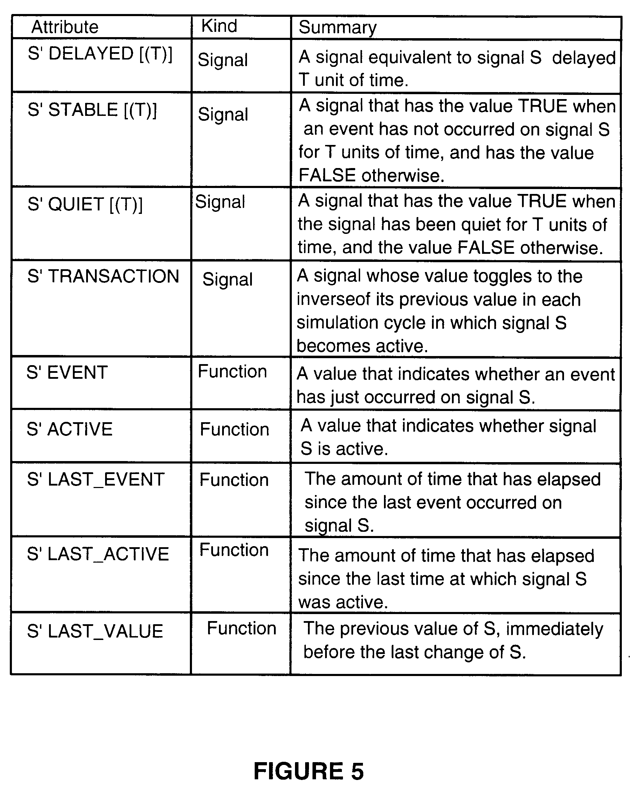

After the signals are identified, each signal is preferably pre-analyzed to determine 46 which attributes need to be computed to properly evaluate the signal. In VHDL, a signal is characterized by nine attributes, each attribute holding certain information related to the signal. A table of these attributes and their descriptions is provided in Fig. 5. As shown in the second column of the table, the first four attributes are themselves signals which may have their own attributes, while the last five attributes are function attributes which hold values indicative of the status of the signal. While each VHDL signal may be characterized by these nine attributes, not all signals use all nine attributes. In fact, most signals use only a subset of the attributes. Thus, computing all attributes for all signals would be a waste of valuable computation time. To ensure that evaluation of each signal is optimized, each signal is analyzed prior to simulation to determine which attributes are used by that signal in the simulation. This pre-analysis is accomplished by traversing the design hierarchy of the simulation model. (How exactly do you determine which signals use which attributes?)

After it is ascertained which attributes are used by each of the signals, the method chain for each signal is generated 48. A method chain is generated 48 by linking together a plurality of methods, each method designed to perform a selected function. The functions that need to be performed, and hence, the methods that need to be included in the method chain, are determined from the attributes used. That is, to compute each attribute, some function or functions must be performed. By using the list of used attributes and by determining which function or functions need to be performed to compute each attribute, a list of required methods is compiled. These methods are linked together to form the method chain. In some instances, other methods may need to be performed to support the simulation, and in such instances, other methods may be linked to the method chain. To ensure that the method chain performs no unnecessary functions, no methods other than those which are required are linked to the method chain. A method chain thus generated will optimally evaluate a signal when the method chain is executed.

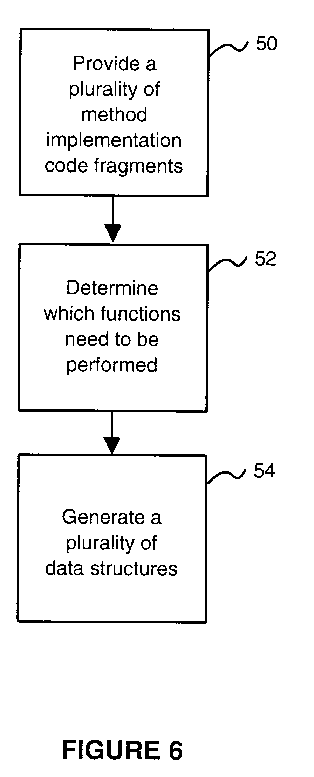

The process of generating 48 a method chain is shown in greater detail in the flow chart of Fig. 6, wherein the first step in the generation process 48 is the provision 50 of a plurality of method implementation code fragments (MICF). Each of these code fragments is a set of computer code which is designed to perform a selected function. It is these code fragments which perform the methods discussed above. The provision of these MICF's sets forth a pool of methods which may be called upon to perform the functions necessary to compute the various attributes. In the preferred embodiment, the MICF's are captured in native machine code because they execute faster in this form, but if desire, they may be written in an interpretive code (pseudo code, for example) or in a compiled form of higher level programming language (such as C), so long as the linkage between MICF's is preserved. More will be said on this point in a subsequent section.

A preferred characteristic of these code fragments is that they be written in a manner which allows them to be shared among a plurality of calling entities. That is, each fragment preferably takes the form of an independent module which may be independently accessed by any calling entity. This requirement is important because in significantly reduces the memory required to run a simulation. The benefits of this requirement will become clear as the generation process is further described. The specific function performed by each code fragment, and the manner in which each function is carried out, are matters of design choice. It is within the ability of one of ordinary skill in the simulation art to construct such code fragments according to his own specifications; thus, the specific structure of each code fragment need not be described in detail herein.

Once the code fragments for implementing the various methods are provided, the next step in the generation process 48 is to determine 52 which of the methods to include in the method chain. In the second step 46 (Fig. 4) of the elaboration process, it was determined which attributes are used by the signal in the simulation; hence, a list of used attributes has been compiled. This list is traversed, attribute by attribute, to determine which functions need to be performed to compute each attribute. By traversing the entire list of used attributes, a list of function required to compute all of the used attributes is derived. The methods which implement these required functions are included in the method chain. Depending on the specific simulation system used, other methods may need to be included in the method chain to support simulation. If so, these other methods are preferably added to the list of required methods.

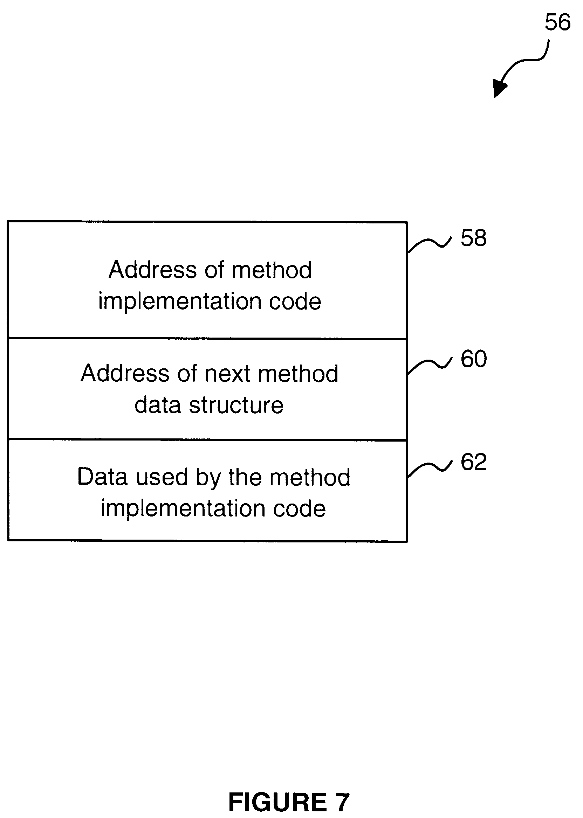

Once the list of required methods is derived, a plurality of method data structures are generated 54 to call the various method implementation code fragments to perform the required methods. A data structure is generated for each of the required methods. In the preferred embodiment, each data structure is an array of data which contains within it a call to one of the code fragments and the data required by that code fragment. Each data structure preferably takes the form shown in Fig. 7, wherein the first data space 58 of the data structure 56 contains the address of the code fragment being called by the structure 56. This data word 58 serves as a pointer to allow the code fragment to be located and accessed. The code fragment is thus "called" by the data structure 56. When a code fragment is called, certain data required by the fragment needs to be supplied. Hence, structure 56 includes a data space 62 in which data used by the code fragment is stored. Each code fragment has its own data structure requirements; thus, the arrangement of data within data space 62 will vary depending on the code fragment being called.

As thus far described, the data structures are merely a group of individual structures, each calling a particular code fragment to perform a particular method. In order for these data structures to form a method chain, they must be linked to one another. The linking of the data structures is achieved by placing in the second data space 60 of each data structure 56 the address of the next data structure on the method chain. In effect, each data structure 56 contains within it a pointer to the next data structure so that a series of data structures may be linked together. Thus, a chain of method-calling structures or a "method chain" is formed.

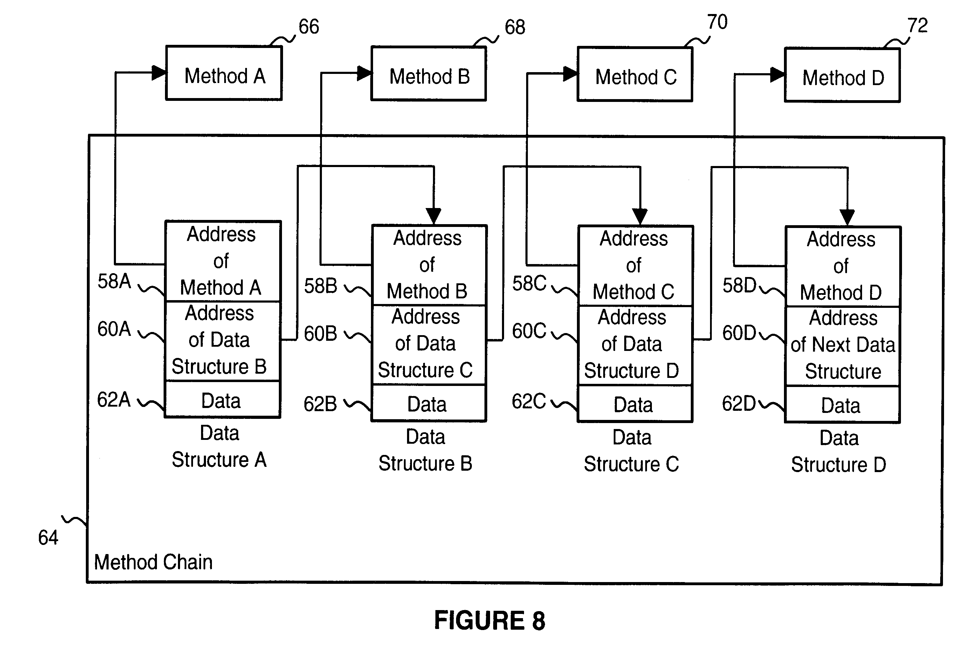

To further illustrate the process of generating a method chain, suppose that a method chain needs to be generated for a signal Z, and that methods A, B, C and D need to be carried out in order to fully evaluate signal Z. The generation of a method chain for signal Z will be described with reference to Fig. 8. Since it is known that methods A, B, C and D are to be included on the method chain 64, the first step in the generation process is to provide method implementation code fragments 66, 68, 70, 72 for carrying out methods A, B, C and D, respectively. Thereafter, a plurality of data structures A, B, C, D are generated, each data structure corresponding to and calling one of the code fragments 66, 68, 70, 72. As shown in Fig. 8, data structure A is constructed such that its first data space 58A contains the address of code fragment 66, its second data space 60A contains the address of the next data structure (which is data structure B), and its third data space 62A contains the data required by code fragment 66. Similarly, data structure B is constructed such that its first data space 58B contains the address of code fragment 68, its second data space 60B contains the address of the next data structure (data structure C), and its third data space 62B contains the data required by code fragment 68. The remaining data structures C, D are constructed in a similar fashion. Constructed in this manner, each data structure contains within it a call to a corresponding code fragment and a link to a subsequent data structure. That is, each data structure has in its first data space 58A-58D the address of a corresponding code fragment 66-72. This functions as a call to the code fragment. Also, each data structure has in its second data space 60A-60B the address of a subsequent data structure. This serves as a link to bind all of the data structures to each other. Together, data structures, A, B, C, D form the method chain 64 for signal Z.

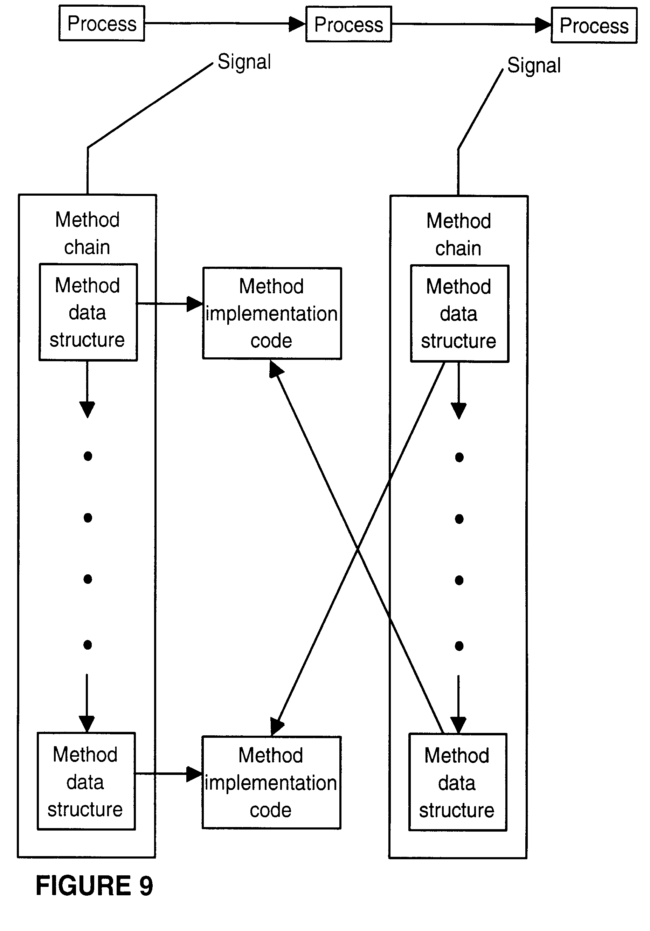

To provide an overview of what has been described thus far, a graphical representation of the various elements in the elaboration process is provided in Fig. 9. In Fig. 9, three processes are shown with two signals communicatively connecting them. Each of the signals has associated with it a method chain comprising a plurality of method data structures, each method data structure calling a corresponding method implementation code fragment. The diagram of Fig. 9 illustrates an important point, which is that the method implementation code fragments are shared by a plurality of data structures. Recall that one of the preferred characteristics of the code fragments is that they be independent modules. This modular independence aspect of the fragments allows them to be independently accessed and shared by a plurality of method data structures, even those in different method chains, as shown in Fig. 9.

The sharing of code fragments amount the various method chains is very advantageous because it minimizes the computer memory required to run a simulation. To elaborate, suppose that the code fragments are not shared, but instead, are incorporated into the various method chains. This would mean that, instead of having only one set of implementation code fragments stored in memory, there would be a plethora of sets of code fragments incorporated into the method chain. If the number of method chains is large, as is typically the case for complex simulation models, the number of sets of code fragments would be huge. Considering that the method chains themselves are stored in memory, incorporating the code fragments into the method chains would require an enormous amount of computer memory. If, on the other hand, only one set of code fragments is provided, and these code fragments are shared among all of the method chains, as in the present invention, then the memory required to store the code fragments would be minimized. The memory required to run a simulation would in turn be minimized. For these reasons, the code fragments of the present invention are preferably constructed as independent modules.

One consequence that flows from having code fragments which are independent modules is that each of the code fragments is preferably written with an implicit reference to its corresponding calling structure. That is, because each code fragment may be called by any data structure, there needs to be some means for communicating to the code fragment which data structure is initiating the call. In the preferred embodiment, each time a code fragment is called, the address of the calling data structure is loaded into a prearranged computer hardware register (generic register Sr0, for example). Hence, the code fragment can locate the calling data structure simply by consulting the prearranged hardware register Sr0. The implicit reference to the calling structure is thus provided. Preferably, each code fragment is programmed to recognize the prearranged register usage.

Other prearranged register usages are preferably programmed into each of the code fragments. Each method chain is a series of calls to code fragments to perform the functions necessary to evaluate a particular signal. Ideally, the code fragments called by the chain should work together as a unit, passing data from one to another to perform a series of operations using data specific to that particular signal. However, each method chain is just a series of calls to a plurality of independent code fragments. The independent code fragments will not function as a unit, nor will they pass data from one to another, unless a mechanism is provided for this purpose. In the preferred embodiment, data is passed between code fragments by way of prearranged computer hardware register usage. For example, generic register Sr1 is used to store the new signal data value, generic register Sr2 is used to store the old signal value, and generic register Sr3 is used to store the address of a signal data storage cell. These hardware registers serve to hold the designated values across the execution of all the methods on the method chain. Data continuity is thus preserved. Each of the code fragments is preferably programmed to recognize these prearranged register usages. In the preferred embodiment, the code fragments are captured in native machine code; thus, the use of prearranged hardware registers is proper. If the code fragments instead take the form of pseudo code or compiled C code, data may be passed between methods by using global variables.

The elaboration step 24 (Fig. 1) of the present invention has now been fully described. By implementing the steps described above, a customized method chain may be generated for each signal in the simulation model. After all of the method chains are generated, the simulation process is commenced. Referring again to Fig. 1, the first step in the simulation process is the dynamic alteration 26 of the method chains. This step 26 allows a user of the simulation system to interactively alter the method chains during simulation to fit his specific needs. The interactive adaptability of the method chain is mainly a function of its linked nature. Recall that a method chain comprises a plurality of data structures, each data structure linked to a subsequent data structure by a pointer stored in the second data space 60 (Fig. 7). Nothing else, either structural or logical, binds the data structures together. Thus, a data structure may be added or removed from a method chain by simply altering the appropriate pointers.

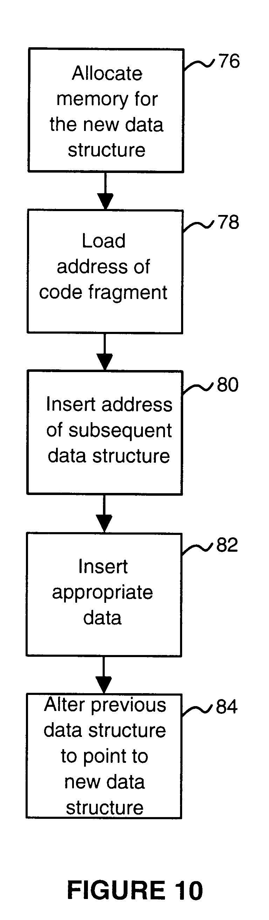

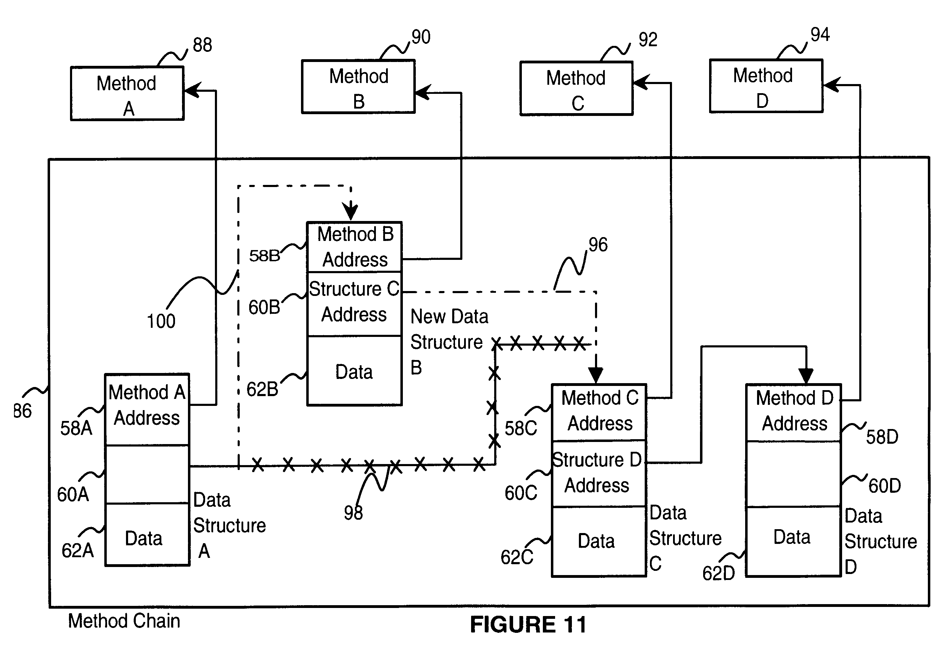

A flow chart illustrating the steps involved in inserting a new data structure into an existing method chain is provided in Fig. 10. The flow chart of Fig. 10 will be explained with reference to the example shown in Fig. 11. In Fig. 11, a method chain 86 is shown initially having three data structures A, C, D calling three code fragments 88, 92, 94, respectively. A new data structure B is inserted into the method chain 86 between data structures A and C to call code fragment 90. The process of inserting the new data structure B into the method chain 86 will now be described.

With reference to Fig. 10, the first step 76 in the insertion process is to allocate 76 a memory block for the new data structure B to provide a memory space wherein data for the new structure may be stored. New structure B is shown in Fig. 11 as occupying an allocated data block. After memory is allocated, the address of the code fragment 90 being called by the new data structure B is loaded 78 into the first data space 58B of the structure. Because the user is interactively adding the new structure B to the method 86, it is presumed that the user knows which code fragment is being called and where that code fragment is located. Thus, the address of the desire code fragment 90 is loaded into the first data space 58B to allow structure B to call the fragment 90. The next step 80 in the process is to insert 80 into the second data space 60B of the new structure B the address of the data structure which should follow the new structure. Since it is desired to insert structure B between structures A and C, the data structure which should follow the new structure B is data structure C. Therefore, the address of structure C is loaded into data space 60B of structure B. Structure B is thus linked to structure C, as shown by dotted line 96. Once the second data space 60B of structure B is loaded, data required by code fragment 90 is loaded 82 into the third data space 62C to supply the code fragment 90 with the necessary data.

The method chain 86 as it now stands is improperly linked because both structures A and B are linked to structure C. Recall the method chain 86 initially had only structures A, C and D; thus, structure A was and still is linked to structure C. To properly incorporate structure B into the chain 86, the pointer stored in the second data space 60A of structure A needs to be altered 84 (Fig. 10) to point to data structure B instead of data structure C. This pointer alteration is preferably accomplished by loading the address of data structure B into the second data space 60A. Such an action establishes the link 100 between structure A and structure B and, at the same time, servers the link 98 between structure A and structure C. Data structure B is thus incorporated into the data chain 86.

Removing a data structure from a data chain is a simple matter. The only action required is the alteration of a single pointer. With reference to Fig. 11, structure B may be removed from the chain 86 by loading the address of structure C into the second data space 60A of structure A. This single action reestablishes the link between structures A and C, and severs the link between structures A and B. Structure B, and hence, method B, is thus effectively removed from the method chain 86.

The dynamic alteration process of the present invention is advantageous in that it allows a user to dynamically add a method to a method chain when that method is needed, and to remove a method when that method is no longer necessary. Thus, a user may selectively alter each method chain to optimize signal evaluation efficiency. Any methood may be added to or removed from a chain using the above process, but there are several methods which are most likely to be dynamically added or removed.

One such method is the monitor method. A monitor method situated within the method chain of a particular signal suspends the simulation process after each evaluation of that signal. This allows the user to closely check or monitor the status of the signal. While signal monitoring is very useful, it slows down the simulation process significantly. Hence, signal monitoring should be used only when necessary. The dynamic alteration process of the present invention allows the user to judiciously insert and remove the monitor method from any method chain. If monitoring is needed, the monitor method is dynamically added to a method chain. When monitoring is no longer needed, the monitor method is removed so that it does not unnecessarily burden the simulation system. Thus, no computational resources are wasted on monitoring when it is not needed.

Another method which is well-suited for dynamic addition and deletion is the freeze method. This method when included in a method chain causes a signal to be unable to change values. Such a method is useful to simulate defective components and stuck-at conditions. Obviously, the freeze method should be used selectively. The dynamic alteration process allows the user to use the method selectively to freeze and unfreeze selected signals during simulation.

The process wait method is another likely candidate for dynamic addition and deletion. In VHDL, a process may sometimes wait on a signal before it runs. That is, the process suspends operation until the signal is evaluated. If a process is waiting on a signal, the signal needs to have a mechanism for alerting the waiting process that it has been evaluated so that the process will "wake up" and resume running. The process wait method is such a mechanism. If a process is waiting on a signal, the process wait method is inserted into the signal's method chain. Otherwise, the method is omitted from the chain to prevent the waste of computation time. Overall, the dynamic alteration capability of the present invention prevents the waste of computational resources by allowing methods to be dynamically added when needed, and removed when no longer needed. Thus, no unnecessary methods are performed. The present invention greatly improves the efficiency of the simulation process.

Referring to Fig. 1 again, once all of the method chains are in a form satisfactory to the user, the chains are executed 28. The execution of the method chains evaluates the signals in the simulation model, thus, completing the signal evaluation process of the present invention.

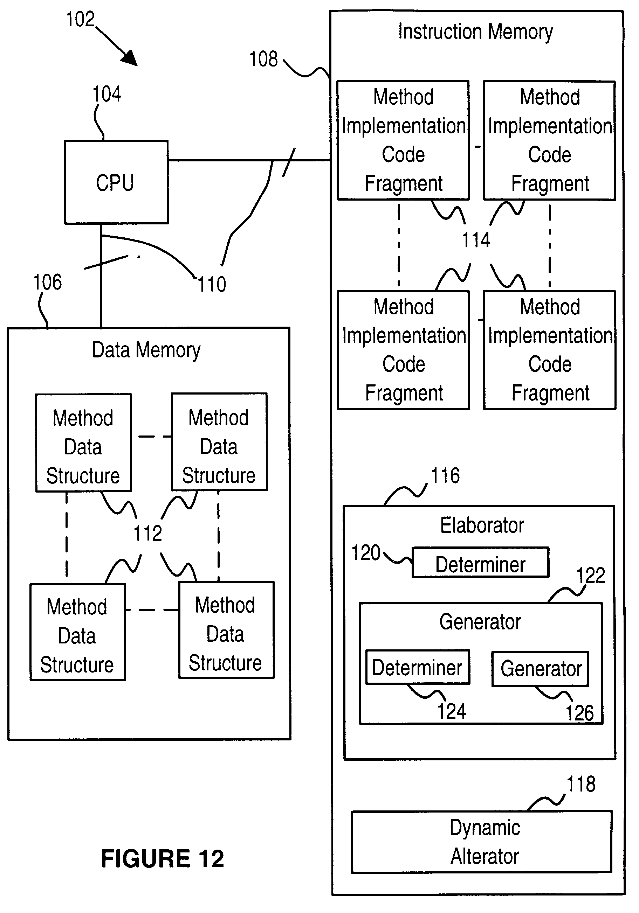

With reference to Fig. 12, there is shown a system for implementing the signal evaluation process of the present invention. The system 102 preferably comprises a CPU 104 and two memories, a data memory 106 and an instruction memory 108, both of which are coupled to the CPU 104 via bus lines 110. The CPU 104 is preferably a microprocessor of standard construction, and both memories 106, 108 are preferably random access memories of standard construction.

Within the data memory 106 are stored a plurality of method data structures 112. Each of the data structures 112 preferably takes the form shown in Fig. 7, wherein the data structure comprises three data spaces 58, 60, 62, each data space storing an appropriate address or data as previously described. Preferably, each data structure 112 is linked to at least one other data structure to form a part of a method chain.

Stored within the instruction memory 108 are the instruction codes which are executed by the CPU; specifically, memory 108 contains a plurality of method implementation code fragments 114, an elaborator 116 and a dynamic alterator 118. With regard to the code fragments 114, each is preferably a set of native machine code which is designed to perform a selected function. Each code fragments 114 is preferably an independent module which can be independently accessed and called by a plurality of the data structures 112 stored within data memory 106.

The entity which is responsible for carrying out the elaboration process of the present invention is elaborator 116. The elaborator 116 is preferably a computer program which performs the steps shown in Figs. 4 and 6. Elaborator 116 comprises a determiner portion 120 for determining which attributes are used by each signal in the simulation model, and a generator portion 122 for generating a method chain for each signal. Within generator portion 122 is a determiner portion 124 and a generator portion 126. Determiner 124 determines, based on the attributes used by a signal, which of the code fragments 114 need to be called to evaluate the signal. It is determiner 124 which compiles the list of needed code fragments. Using this list of code fragments, the generator 126 generates, for each code fragment on the list, a data structure 112 for calling the code fragment. Generator 126 also links the data structures 112 together to form a method chain. In short, the elaborator program 116 carries out the steps shown in Figs. 4 and 6 and described in the corresponding text.

Also stored within instruction memory 108 is dynamic alterator 118. Alterator 118 is preferably a computer program which carries out the steps shown in Fig. 10 and described in the corresponding text. Specifically, alterator 118 allocates memory for a new data structure, loads data into the appropriate data space, and alters the appropriate pointers to allow a user to dynamically add a method to a method chain. Alterator 118 also alters the appropriate pointers to allow a user to dynamically remove a method from a chain. In short, alterator 118 is the means for carrying out the dynamic alteration process.

## Claims

1. A process for evaluating a simulation signal having a plurality of attributes, comprising the steps of:
determining which of the attributes are used to characterize said signal for a particular simulation; and
generating a method chain for computing the used attributes for said signal.

2. The process of claim 1, wherein said method chain comprises a plurality of methods, each method performing a selected function, said plurality of methods performing a set of functions needed to compute said used attributes.

3. The process of claim 2, wherein each of said methods is linked to at least one other method to form said method chain.

4. The process of claim 1, wherein the step of generating comprises the steps of:
providing a plurality of program code fragments, each code fragment capable of performing a function;
determining which functions need to be performed to compute said used attributes; and
generating a plurality of data structures, each data structure calling one of said code fragments to perform one of the needed functions.

5. The process of claim 4, wherein said data structures are linked together to form said method chain.

6. The process of claim 5, wherein at least one of said data structures has a data word which is an address of a subsequent data structure in said method chain.

7. The process of claim 4, wherein each of said data structures has a data word which is an address of a corresponding code fragment.

8. The process of claim 4, wherein each of said code fragments is an independent module which may be independently accessed by a plurality of data structures.

9. The process of claim 1, further comprising the step of:
dynamically altering said method chain by inserting a method into said method chain during simulation.

10. The process of claim 1, further comprising the step of:
inserting into said method chain a monitor method for monitoring said signal during simulation.

11. The process of claim 1, further comprising the step of:
inserting into said method chain a freeze method for performing a freeze function during simulation to simulate a stuck-at condition.

12. The process of claim 1, further comprising the step of:
inserting into said method chain a process wait method for providing an indication that said signal is being evaluated.

13. The process of claim 2, further comprising the step of:
dynamically altering said method chain by removing one of said methods from said method chain during simulation.

14. The process of claim 1, further comprising the step of:
executing said method chain to evaluate said signal.

15. A system for evaluating a signal having a plurality of attributes, comprising:
means for determining which attributes are used for a particular simulation; and
means for generating a method chain for computing the used attributes for said signal.

16. The system of claim 15, wherein said method chain comprises a plurality of methods, each method performing a selected function, said plurality of methods performing a set of functions needed to compute said used attributes.

17. The system of claim 16, wherein each of said methods is linked to at least one other method to form said method chain.

18. The system of claim 15, further comprising:
a plurality of program code fragments, each code fragments capable of performing a selected function.

19. The system of claim 18, wherein said generating means comprises:
means for determining which functions need to be performed to compute said used attributes; and
means for generating a plurality of data structures, each data structure calling one of said code fragments to perform one of the needed functions.

20. The system of claim 19, wherein said generating means links said data structures together to form said data chain.

21. The system of claim 20, wherein at least one of said data structures has a data word which is an address of a subsequent data structure in said method chain.

22. The system of claim 19, wherein each of said data structures has a data word which is an address of a corresponding code fragment.

23. The system of claim 18, wherein each of said code fragments is an independent module which may be accessed by a plurality of data structures.

24. The system of claim 15, further comprising:
dynamic altering means for inserting a method into said method chain during simulation.

25. The system of claim 16, further comprising:
dynamic altering means for removing one of said methods from said method chain during simulation.
